# EUROPEAN PATENT SPECIFICATION

(11) **EP 4 282 042 B1**
(45) Date of publication and mention of the grant of the patent: **08.07.2026**
(21) Application number: 21707048.1
(22) Date of filing: 21.01.2021
(51) Int. Cl.: H01S 5/02257, G02B 27/10, H04N 9/31, H01S 5/0683, G02B 27/01, H01S 5/00, H01S 5/0222, H01S 5/40

(54) **INTEGRATED LASER PACKAGE WITH LIGHT INTENSITY MONITORING**
INTEGRIERTES LASERGEHÄUSE MIT LICHTINTENSITÄTSÜBERWACHUNG
BOÎTIER LASER INTÉGRÉ À SURVEILLANCE D'INTENSITÉ LUMINEUSE

(43) Date of publication of application: 29.11.2023
(73) Proprietor: Google LLC, Mountain View, CA 94043 (US)
(72) Inventor: ADEMA, Daniel, Mountain View, California 94043 (US); BODIYA, Timothy Paul, Mountain View, California 94043 (US)
(74) Representative: Maikowski & Ninnemann Patentanwälte Partnerschaft mbB
(86) International application number: PCT/US2021/014389
(87) International publication number: WO 2022/159089

(56) References cited:
- EP-A1- 3 226 065
- US-A- 5 247 167
- US-A- 5 761 229

## Description

### BACKGROUND

A projector is an optical device that projects or shines a pattern of light onto another object (e.g., onto a surface of another object, such as onto a projection screen) in order to display an image or video on that other object. A laser projector is a projector for which the light source comprises at least one laser, where the laser is temporarily modulated to provide a pattern of laser light that is then spatially distributed over a display area of another object (e.g., a screen or lens) to display an image or video. In order to better control the performance of a laser projector, it is sometimes advantageous to monitor the laser output power of the laser projector. For example, accurately monitoring the laser output power of the laser projector would allow the laser projector to control the laser output power to adjust and tune the white point and/or brightness of the display.

EP 3 226 065 A1 discloses a light module and a method for monitoring laser diodes in the light module.

### SUMMARY

A laser projector according to the claimed invention is defined in appended claim 1 and includes a photodetector configured to measure light intensity and an optical engine.

In some embodiments, the laser projector includes an enclosure that surrounds the laser source and that includes the exit window.

In some embodiments, the diffraction grating is a holographic diffraction grating.

In some embodiments, the diffraction grating is a surface-relief diffraction grating.

In some embodiments, at least a portion of the diffraction grating that overlaps the optical path of the light beam has a resonant wavelength corresponding to the wavelength of the light beam.

In some embodiments, the optical engine is disposed on a surface of a substrate, the photodetector is disposed across from a side wall of the exit window of the enclosure, the side wall is adjacent to the primary output surface and defines a plane that is perpendicular to the surface of the substrate, and the diffraction grating redirects the portion of the light beam toward the photodetector through the side wall of the exit window.

In some embodiments, the optical engine is disposed on a substrate, the photodetector is disposed directly beneath the exit window and directly beneath the optical path of the light beam, and the diffraction grating redirects the portion of the light beam toward the photodetector through a bottom surface of the exit window that faces the substrate.

In some embodiments, the photodetector is embedded in the substrate.

In some embodiments, the optical engine is disposed on a first side of the substrate, the photodetector is disposed on a second side of the substrate that is opposite the first side, and the diffraction grating redirects the portion of the light beam toward the photodetector through the bottom surface of the exit window and through an aperture that extends through the substrate from the first side to the second side.

In some embodiments, the optical engine is disposed on a first substrate, the photodetector is disposed on a second substrate that is disposed over the first substrate such that the photodetector is disposed directly over the exit window and the optical path of the light beam, and the diffraction grating redirects the portion of the light beam toward the photodetector through a top surface of the exit window that faces toward the second substrate and faces away from the first substrate.

In some embodiments, the primary output surface of the exit window is slanted with respect to a primary input surface of the exit window, and the light beam is incident on the primary input surface of the exit window.

In an embodiment, the optical engine includes a plurality of laser sources configured to output a plurality of light beams, an enclosure that surrounds the plurality of laser sources, the enclosure having the exit window disposed in each optical path of the plurality of light beams output by the plurality of laser sources. The diffraction grating redirects a portion of each of the plurality of light beams toward the at least one photodetector.

In some embodiments, the laser projector includes a collimating lens between the exit window and the at least one photodetector.

In some embodiments, the diffraction grating includes a first portion having a first resonant wavelength that corresponds to a first wavelength of a first light beam of the plurality of light beams. The first portion overlaps a first optical path of the first light beam. The diffraction grating further a second portion having a second resonant wavelength that corresponds to a second wavelength of a second light beam of the plurality of light beams. The second portion overlaps a second optical path of the second light beam.

In some embodiments, the optical engine is disposed on a surface of a substrate, the at least one photodetector includes a first photodetector that is disposed across from a first side wall of the exit window of the enclosure, the first side wall is adjacent to the primary output surface and defines a plane that is perpendicular to the surface of the substrate, and the diffraction grating redirects a first portion of at least a first light beam of the plurality of light beams toward the first photodetector through the first side wall of the exit window.

In some embodiments, the at least one photodetector includes a second photodetector that is disposed across from a second side wall of the exit window of the enclosure, the second side wall is opposite the first side wall, and the diffraction grating redirects a second portion of at least a second light beam of the plurality of light beams toward, the second photodetector through the second side wall of the exit window.

In some embodiments, the optical engine includes a first dichroic filter disposed on the first side wall of the exit window and a second dichroic filter disposed on the second side wall of the exit window, the first dichroic filter is configured to be transmissive of a first wavelength of light corresponding to that of the first light beam and to be reflective of a second wavelength of light corresponding to that of the second light beam, and the second dichroic filter is configured to be transmissive of the second wavelength of light and to be reflective of the first wavelength of light.

In some embodiments, the optical engine is disposed on a substrate, and the at least one photodetector includes a first photodetector that is disposed directly beneath the exit window and directly beneath a first optical path of a first light beam of the plurality of light beams, the diffraction grating redirecting a first portion of the first light beam toward the first photodetector through a bottom surface of the exit window that faces the substrate, and a second photodetector that is disposed directly beneath the exit window and directly beneath a second optical path of a second light beam of the plurality of light beams, the diffraction grating redirecting a second portion of the second light beam toward the second photodetector through the bottom surface of the exit window.

In some embodiments, the first photodetector and the second photodetector are each embedded in the substrate.

In some embodiments, the optical engine is disposed on a first side of the substrate, the first photodetector and the second photodetector are each disposed on a second side of the substrate that is opposite the first side, the diffraction grating redirects the first portion of the first light beam toward the first photodetector through the bottom surface of the exit window and through a first aperture that extends through the substrate from the first side to the second side, the diffraction grating redirects the second portion of second first light beam toward the second photodetector through the bottom surface of the exit window and through a second aperture that extends through the substrate from the first side to the second side.

In some embodiments, the optical engine is disposed on a first substrate, the at least one photodetector is disposed on a second substrate that is disposed over the first substrate such that the at least one photodetector is disposed directly over the exit window and directly over at least one of the optical paths of the plurality of light beams, and the diffraction grating redirects at least one portion of at least one of the plurality of light beams toward the at least one photodetector through a top surface of the exit window that faces toward the second substrate and faces away from the first substrate.

In some embodiments, the primary output surface of the exit window is slanted with respect to a primary input surface of the exit window, and the light beam is incident on the primary input surface of the exit window.

The optical engine includes a laser source configured to output a light beam, an exit window disposed in an optical path of the light beam output by the laser source, the exit window receiving the light beam via a primary input surface of the exit window, and a diffraction grating disposed on a primary output surface of the exit window, the diffraction grating redirecting a portion of the light beam through at least one surface of the exit window that extends between the primary input surface and the primary output surface.

In some embodiments, a majority of the light beam exits the exit window.

In some embodiments, the laser source is a first laser source, the light beam is a first light beam, and the optical engine includes a second laser source configured to output a second light beam, a first dichroic filter disposed on the first side wall of the exit window, and a second dichroic filter disposed on the second side wall of the exit window. The first dichroic filter is configured to be transmissive of a first wavelength of light corresponding to that of the first light beam and to be reflective of a second wavelength of light corresponding to that of the second light beam, and the second dichroic filter is configured to be transmissive of the second wavelength of light and to be reflective of the first wavelength of light.

In some embodiments, the optical engine is disposed on a surface of a substrate and the diffraction grating redirects the portion of the light beam through a bottom surface of the exit window that faces the substrate.

In some embodiments, the optical engine is disposed on a surface of a substrate and the diffraction grating redirects the portion of the light beam through a top surface of the exit window that extends between the primary input surface and the primary output surface and that faces away from the substrate.

### BRIEF DESCRIPTION OF THE DRAWINGS

The present disclosure may be better understood, and its numerous features and advantages made apparent to those skilled in the art by referencing the accompanying drawings. The use of the same reference symbols in different drawings indicates similar or identical items.
FIG. 1 is a block diagram of a side view of a wearable heads-up display in accordance with some embodiments.
FIG. 2 is an isometric view of a wearable heads-up display with a laser projector that includes an optical engine, in accordance with some embodiments.
FIG. 3 is a block diagram of a top-down view of a laser projector that includes a discrete pickoff component for redirecting a portion of laser light to a photodetector.
FIG. 4 is a block diagram of a top-down view of a laser projector having an optical engine that includes an exit window having a holographic diffraction grating, in accordance with some embodiments.
FIG. 5 is a block diagram of a top-down view of a laser projector having an optical engine that includes an exit window having a reflective surface-relief diffraction grating, in accordance with some embodiments.
FIG. 6 is a block diagram of a top-down view of a laser projector having an optical engine that includes an exit window having a diffraction grating, where a portion of laser light incident on the diffraction grating is redirected through both side surfaces of the exit window and through respective color filters toward photodetectors that are aligned with the side surfaces, in accordance with some embodiments.
FIG. 7 is a block diagram of a side view of a laser projector having an optical engine that includes an exit window having a diffraction grating, where a portion of laser light incident on the diffraction grating is redirected through a bottom surface of the exit window toward a photodetector that is embedded in the substrate on which the exit window is disposed, in accordance with some embodiments.
FIG. 8 is a block diagram of a side view of a laser projector having an optical engine that includes an exit window having a diffraction grating, where a portion of laser light incident on the diffraction grating is redirected through a bottom surface of the exit window, through a pass-through aperture in the substrate on which the exit window is disposed, and toward a photodetector that is disposed on an opposite side of the substrate from the exit window, in accordance with some embodiments.
FIG. 9 is a block diagram of a side view of a laser projector having an optical engine that includes an exit window having a diffraction grating, where the exit window is disposed on a first substrate, and where a portion of laser light incident on the diffraction grating is redirected through a top surface of the exit window, toward a photodetector that is disposed on a second substrate located above the top surface of the exit window, in accordance with some embodiments.
FIG. 10 shows perspective and side views of an exit window having a primary output surface that slants upward and outward from the bottom surface of the exit window to the top surface of the exit window, in accordance with an embodiment.
FIG. 11 shows perspective and side views of an exit window having a primary output surface that slants downward and outward from the top surface of the exit window to the bottom surface of the exit window, in accordance with an embodiment.
FIG. 12 shows perspective and side views of an exit window having a primary output surface that slants rightward and outward from the left side surface of the exit window to the right side surface of the exit window, in accordance with an embodiment.

### DETAILED DESCRIPTION

The present disclosure describes systems and methods for providing laser projectors having laser-based optical engines as well as light intensity and/or laser output power measuring (e.g. monitoring) capabilities. According to the various embodiments described herein, an optical engine of a laser projector includes at least one laser source (e.g., a laser diode or a plurality of laser diodes) that may be enclosed in a (e.g. partially or completely hermetically sealed) enclosure. The enclosure may include an optical window (sometimes referred to herein as an "exit window") that may be integrated with one of its side walls or top surface or that forms one of its side walls or top surface. Laser light beams output by the laser source(s) may pass through the exit window to exit the enclosure during active operation of the laser projector. The optical engine may support a relatively small substrate area for power monitoring, reducing the overall size of the optical engine. The laser projector or the optical engine can therefore be flexibly employed in a variety of display designs, including wearable heads-up displays or other head-mounted displays. In some embodiments, after passing through the exit window, the light beams are passed through respective collimating lenses to a dichroic filter/beam combiner, at which light beams of different wavelengths are combined. The combined light beams may then be directed to one or more scanning elements that project the light beams across a display surface of an object, such as the holographic lens of a pair of smart glasses or another type of wearable heads-up display. While various embodiments described herein are provided in the context of a wearable heads-up display, it should be understood that the laser projector and optical engine of the present disclosure can instead be included in other systems, such as projection engines, lidar systems, sensing systems, ranging systems, external cavity laser diodes (e.g., as an integrated intensity stabilization servo), and/or the like.

It is generally desirable to monitor the laser output power of the laser sources of the optical engine of the laser projector, which allows for improved control over the quality of the projected image or video and enables a controller or processor of the device that includes the laser projector to dynamically limit the maximum output power of the optical engine based on real-time or near-real-time measurements of the laser output power. For example, laser output power monitoring tends to be particularly important for the design of laser projectors used in wearable heads-up displays due to the generally limited availability of power and space (e.g., volume) in such wearable devices. Conventional methods for designing a laser projector with laser output power monitoring capabilities require a relatively large footprint on the laser projector substrate, which may be a printed circuit board (PCB) to be dedicated to the placement of a photodetector such as a photodiode, to the placement of optical components such as a pickoff mirror, and to maintaining a clear optical path to the photodetector. In some instances, this footprint may be as large as that of the optical engine itself. Accordingly, it would be advantageous to reduce the substrate area taken up by the photodetector(s) and/or optical component(s) (sometimes referred to collectively herein as "laser output power monitoring component(s)") that implement laser output power monitoring for an optical engine of a laser projector.

The systems, devices, and techniques described herein may provide a reduction in the substrate area required for laser power output monitoring components, e.g. by utilizing an exit window of an enclosure of an optical engine having e.g. a diffraction grating that may be disposed in or on a primary output surface of the exit window and that may redirect (e.g., via diffraction) a portion of the incident light from the laser light beam(s) output by the laser source(s) toward one or more photodetectors, which may be photodiodes, and which may be disposed across from one or more surfaces of the exit window. According to various embodiments, the exit window includes a diffraction grating that can be disposed or formed on or in the exit window, and that redirects the incident light from the laser sources toward the one or more photodetectors. In some embodiments, one or more photodetectors may be disposed on a top surface of the substrate so as to receive light that is redirected by the diffraction grating and that is output through a one or both side walls of the exit window. A "side wall" or "side surface" of the exit window may be defined as a surface of the exit window that extends between the primary input surface of the exit window and the primary output surface of the exit window that defines a plane that intersects (e.g., that is perpendicular to) the surface of the substrate upon which the optical engine is disposed. In some embodiments, one or more photodetectors may be disposed below the exit window and completely or partially embedded in the substrate, such that the one or more photodetectors receive light that is redirected by the diffraction grating and that is output through a bottom surface of the exit window. In some embodiments, the exit window is disposed on a first side of the substrate and one or more photodetectors, which may be photodiodes, may be disposed below the exit window on a second side of the substrate that is opposite the first side, such that the one or more photodetectors receive light that is redirected by the diffraction grating and that is output through a bottom surface of the exit window, which passes through one or more apertures that extend through the entire thickness of the substrate to reach the one or more photodetectors. In some embodiments, one or more photodetectors may be disposed above the exit window on the surface of a second substrate that opposes the surface of the first substrate on which the window is disposed, such that the one or more photodetectors receive light that is redirected by the diffraction grating and that passes through a top surface of the window.

While the exit window may generally be rectangular cuboidal in shape, it may be beneficial to slant the primary output surface (i.e., the surface through which the laser light beams output by the laser sources pass) of the exit window to be non-orthogonal to the respective axes (i.e., respective main principal axes) along which the laser light beams output by the laser sources propagate. By slanting the primary output surface of the exit window, feedback of light redirected by the diffraction grating back into the laser sources is reduced, compared to that of exit windows that are substantially cuboidal. In some embodiments, a primary output surface of the exit window may be slanted upward and outward from the bottom surface of the exit window to the top surface of the exit window. in some embodiments, the primary output surface of the exit window may be slanted downward and outward from the top surface of the exit window to the bottom surface of the exit window, where the bottom surface faces the surface of the substrate on which the optical engine is disposed and the top surface faces away from that substrate. In some embodiments, the primary output surface of the exit window may be slanted outward from a first side surface of the exit window to a second side surface of the exit window.

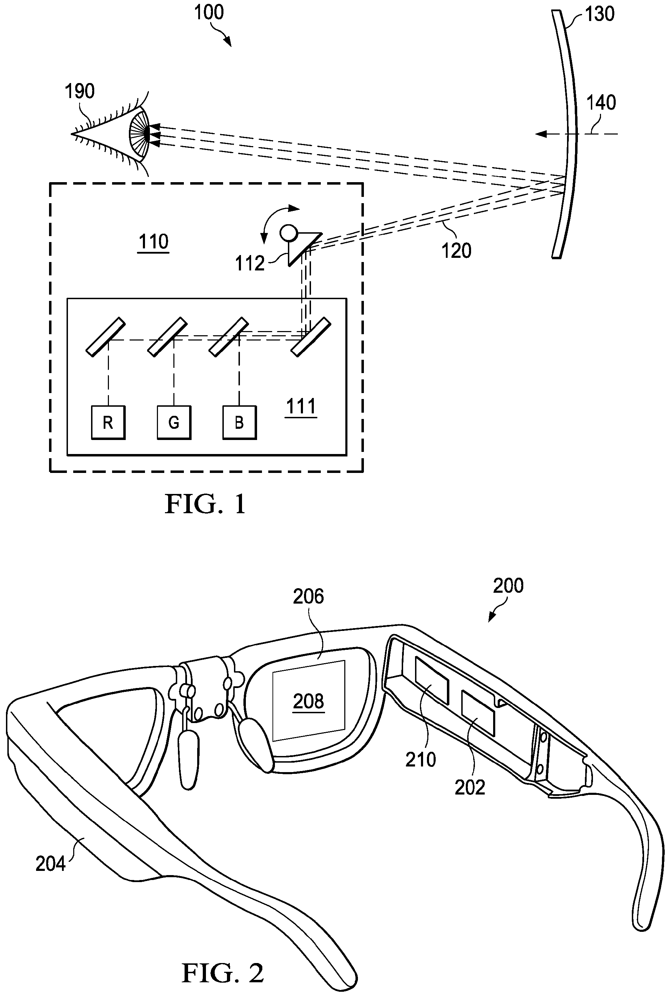

FIG. 1 is an illustrative diagram showing a side view of a wearable heads-up display (WHUD) 100 that employs a laser projector 110, which may be a scanning laser projector. For example, the WHUD 100 may be a pair of smartglasses or a virtual reality (VR) headset. The laser projector 110 comprises an optical engine 111 that includes a red laser diode (labeled "R" in FIG. 1), a green laser diode (labeled "G" in FIG. 1), and a blue laser diode (labeled "B" in FIG. 1), and a scan mirror 112 that is controllably rotatable about two axes of freedom. A single scan mirror 112 that is rotatable about two axes of freedom is used only as an illustrative example herein and a person of skill in the art will appreciate that similar functionality may be realized using a different mirror configuration, such as a configuration in which two scan mirrors are each controllably rotatable about a respective one of two orthogonal axes of freedom and respectively positioned in sequence with respect to the optical path of laser light 120. Laser light 120 output by laser projector 110 may comprise any modulated combination of red laser light (output by the red laser diode), green laser light (output by the green laser diode), and/or blue laser light (output by the blue laser diode). Laser light 120 reflected from the scan mirror 112 is incident on a holographic optical element ("HOE") 130 that redirects the laser light 120 back towards an eye 190 of a user. Generally, in the present disclosure, the term "user" refers to a user of a device that contains a laser projector. In the specific context of FIG. 1, the term "user" refers to a person wearing or using the WHUD 100. A person of skill in the art will appreciate that the WHUD 100 may include a support frame and/or other support/alignment structure(s) (not depicted in FIG. 1 to reduce clutter) that enable a user to wear the elements depicted in FIG. 1 so that at least the HOE 130 is positioned within a field of view of at least one eye 190 of the user when WHUD 100 is worn on a head of the user.

The HOE 130 may be substantially optically transparent to environmental light 140 (i.e., optically transparent to the majority of wavelengths that make up environmental light 140) incident from the opposite side of HOE 130 relative to the laser light 120. Because the HOE 130 effectively combines the projected laser light 120 and the external environmental light 140 in the user's field of view, the HOE 130 may be referred to as a "combiner" or related variant, such as "transparent combiner," "holographic optical combiner," or similar. If the support frame (not illustrated in FIG. 1) of WHUD 100 has the general shape, appearance, and/or geometry of a pair of eyeglasses, then HOE 130 may be carried on one or more transparent lens(es) of the WHUD 100 (such as one or more prescription lenses or one or more non-prescription lenses). In some embodiments, the WHUD 100 may include one or more components such as computer processors and cameras or other sensors that, together, perform eye tracking functions.

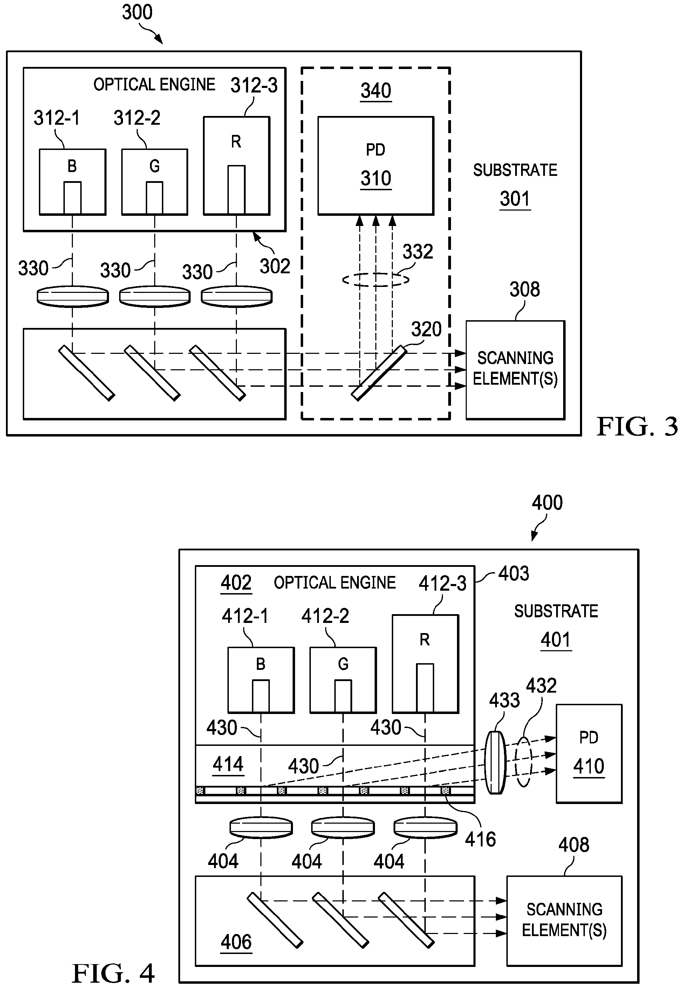

Generally, it is desirable to monitor laser output power in the laser projector 110 in order to better control the image or video projected onto the HOE 130 (i.e., display surface) and to limit the maximum output power of the WHUD 100. Monitoring laser output power in a laser projector such as the laser projector 110 is typically performed using a discrete pickoff component to redirect a portion of the laser light 120 to an on-chip photodetector. However, such laser output power monitoring approaches require a relatively large footprint on the laser projector substrate. In order to reduce the footprint of laser output power monitoring components, an exit window of an enclosure that includes some or all of the components of the optical engine 111 may be configured to redirect a portion of the laser light 120 through top, bottom, or side walls of the exit window toward one or more photodetectors placed across from and in the optical path of the top, bottom, or side walls of the exit window. For example, the optical engine 111 may include a diffraction grating in or on the exit window of its enclosure, where the diffraction grating redirects a portion of the laser light 120 toward one or more photodetectors, which may be photodiodes, and which detect the intensity of the redirected light from which the laser output power of the optical engine 111 of the laser projector 110 may be subsequently derived (e.g., by a computer processor or a fixed or programmable logic circuit of the WHUD 100). Various approaches for using the exit window of an optical engine, such as the optical engine 111, to redirect a portion of laser light are provided below in the various embodiments of FIGS. 4-9.

FIG. 2 is a schematic diagram of a wearable heads-up display (WHUD) 200 with a laser projector 202 in accordance with the present systems, devices, and methods. The WHUD 200 includes a support structure 204 with the shape and appearance of a pair of eyeglasses that in use is worn on the head of the user. The support structure 204 carries multiple components, including eyeglass lens 206, a transparent combiner 208, the laser projector 202, and a controller or processor 210. In some embodiments, the laser projector 202 may be similar or identical to one or more of the laser projectors 110, 400, 500, 600, 700, 800, or 900 of FIGS. 1 and 4-9. For example, the laser projector 202 may include an optical engine, such as the optical engine 111, 402, 502, 602, 702, 802, or 902. The laser projector 202 may be communicatively coupled to the controller 210 (e.g., microprocessor) which controls the operation of the projector 202, as discussed above. The controller 210 may include or may be communicatively coupled to a non-transitory processor-readable storage medium (e.g., memory circuits such as ROM, RAM, FLASH, EEPROM, memory registers, magnetic disks, optical disks, other storage), and the controller may execute data and/or instruction from the non-transitory processor-readable storage medium to control the operation of the laser projector 202.

In operation of the WHUD 200, the controller 210 controls the laser projector 202 to emit laser light. As discussed above with reference to FIG. 1, the laser projector 202 generates and directs an aggregate beam of laser light (e.g., laser light 120 of FIG. 1) toward the transparent combiner 208 via at least one controllable mirror (not shown in FIG. 2). The aggregate beam is directed towards a field of view of an eye of a user by the transparent combiner 208. The transparent combiner 208 may collimate the aggregate beam such that the spot of the laser light incident on the eye of the user is at least approximately the same size and shape as the spot at transparent combiner 208. The transparent combiner 208 may be a holographic combiner that includes at least one holographic optical element.

The optical engine of the laser projector 202 may include an enclosure having an exit window, where one or more components (e.g., laser diodes that output the laser light) of the optical engine are disposed within the enclosure and are completely or partially hermetically sealed by the enclosure. The exit window may include a diffraction grating that is integrated within or disposed on a surface (e.g., the primary output surface through which the majority of the laser light output by the laser diodes exits the enclosure) of the exit window. A portion of the laser light is redirected by the diffraction grating toward one or more photodetectors, which may be photodiodes, and which measure the light intensity of the redirected portion of the laser light. The controller 110 may be configured to determine laser output power the light intensity of the redirected portion of the laser light detected by the one or more photodiodes and to selectively limit the maximum output power of the laser projector based on the detected laser output power. In some embodiments, the controller 210 may additionally or alternatively be configured to control the projection of an image or video by the laser projector based, at least in part, on the detected laser output power. For example, by monitoring the laser output power, the controller 110 may determine the overall and per-color brightness intensities of the laser light beams output by the laser projector 202 in real-time or near-real-time, and the controller 110 may control the overall brightness and the color balance of the laser light beams output by the laser projector 202 based on the determined brightness intensities.

FIG. 3 shows a laser projector 300 that utilizes a pickoff component 320 to redirect laser light to a photodetector (PD) 310. The laser projector 300 includes an optical engine 302 that includes blue (B), green (G), and red (R), laser sources 312-1, 312-2, and 312-3, which output respective laser light beams 330. The light beams are collimated, combined, and directed to scanning elements 308, which project the combined laser light beams onto a display area of an object, such as the lens of a WHUD, so that an image or video represented in the combined laser light beams can be viewed by a user. The light beams 330 are directed through a pickoff component 320 disposed in the optical path between the optical engine 302 and the scanning elements 308. The pickoff component 320 redirects light 332 (sometimes referred to herein as "redirected laser light 332"), which is a portion of the laser light beams 330, to a PD 310, which measures the intensity of the redirected laser light 332. The measured light intensity is then used to calculate and monitor the laser output power of the optical engine 302. The optical engine 302, scanning element(s) 308, pickoff component 320, and PD 310 are all disposed on a substrate 301, which may be a printed circuit board (PCB), for example.

The area 340 of the substrate 301 around the pickoff component 320, the PD 310, and the optical path between the pickoff component 320 and the PD 310 is typically large (e.g., about the same size as the area of the optical engine 302) and takes up space that could otherwise be used for the placement of other components or that could be omitted from the laser projector 300 to reduce the overall substrate area required for the laser projector 300. The techniques described in the embodiments of FIGS. 4 - 9, below, do not require the pickoff component 120, and instead redirect light through one or more top, bottom, or side walls of an exit window of an enclosure of the optical engine, thereby advantageously reducing the substrate area needed for laser output power monitoring.

FIG. 4 shows an illustrative laser projector 400 that uses a holographic diffraction grating to redirect light toward a photodetector, which may be a photodiode. Specifically, the laser projector 400 includes an optical engine 402, collimating lenses 404, a dichroic filter/combiner 406, one or more scanning elements 408, and a PD 410, which are all disposed on a substrate 401. The substrate 401 may be a printed circuit board (PCB), for example.

The optical engine 402 includes a blue laser source 412-1, a green laser source 412-2, a red laser source 412-3. The laser sources 412 may each include one or more laser diodes. Each of the laser sources 412 may be configured to emit a respective laser light beam 430 in a narrow waveband corresponding to the respective color (red, green, or blue) indicated for that laser source 412. In some alternative embodiments, a fourth laser source configured to emit light in an infrared (IR) waveband may be included in the optical engine 402.

The optical engine 402 further includes an enclosure 403 that completely or partially hermetically seals an interior volume, where the laser sources are disposed within that interior volume. The enclosure 403 includes an exit window 414 through which the laser light beams 430 emitted by the laser sources 412 pass during operation of the laser projector 400. In some embodiments, a portion of the substrate 401 forms some or all of a floor of the enclosure 403. The side walls and, in some embodiments, the exit window 414 of the enclosure 403 may be attached to the substrate 401 with adhesive, for example, and the adhesive may form a partial or complete hermetic seal between those elements of the enclosure 403 and the substrate 401. In some alternative embodiments, other adhesion and sealing methods may be used to attach and seal the enclosure 403 to the substrate 404, such as glass soldering, glass frit, and anodic bonding. Apart from the exit window 414, the enclosure 403 may be opaque to block external light from entering the enclosure 403 and to prevent laser light from exiting the enclosure 403 through any other aperture. For example, the ceiling, floor, and side walls of the enclosure 403 (again, with the exception of the exit window 414) may be opaque. In the present example, the exit window 414 forms all or a portion of one sidewall of the enclosure 403 and is disposed in the optical path of the laser light beams output by the laser sources 412. In some alternative embodiments, the exit window 414 forms a portion of a top surface of the enclosure 403 (i.e., disposed opposite from and aligned non-perpendicular to the substrate 401), and one or more mirrors (not shown) enclosed in the enclosure 403 reflect light from the laser sources 412 toward the top surface of the enclosure 403 and through the exit window 414. The exit window 414 receives the laser light beams 430 at a primary input surface that faces the laser sources 412 and outputs the light beams 430 through a primary output surface disposed opposite to the primary input surface.

After exiting the primary output surface of the exit window 414, the laser light beams 430 are collimated by the collimating lenses 404, such that each laser light beam 430 is aligned with minimal spread to focus on the dichroic filter/combiner 406. In some alternative embodiments, one or more polarization beam splitters may be used in place of the dichroic filter/combiner 406. The dichroic filter/combiner 406 combines the laser light beams 430 into a single combined beam and redirect the combined beam toward the scanning elements 408, which project the combined beam onto a display area of an object, such as the lens of a WHUD, so that an image or video represented in the combined beam can be viewed by a user.

The exit window 414 includes a holographic diffraction grating 416, which is dimensioned to redirect (e.g., via diffraction) light 432 (sometimes referred to herein as "redirected laser light 432), which is a portion of the laser light beams 430, through a side wall (e.g., the right side wall, with respect to the orientation depicted in FIG. 4) of the exit window 414, toward a PD 410 that is disposed near the right side wall and in the optical path of some or all of the light redirected through. The PD 410 measures the intensity of the redirected laser light 432. The measured light intensity is then provided to a controller or microprocessor that is coupled to the PD 410, which calculates and monitors the laser output power of the optical engine 402, and which may limit a maximum laser output power of the optical engine 402 based on the calculated laser output power of the optical engine 402.

Diffraction gratings are periodic structures that can be formed by a variety of methods, such as subtractive methods, additive methods, holography (e.g., polarization holography), or combinations thereof. A given diffraction grating may be oriented in a reflective mode (i.e., "reflective diffraction gratings") or a transmissive mode (i.e., "transmissive diffraction gratings"), depending on how the diffraction grating is oriented with respect to incoming light. A diffraction grating can be narrow band or broad band with respect to the range of wavelengths and incident angles of light to which the diffraction grating is responsive. The method of manufacture for a given diffraction grating is generally dependent on the feature sizes needed for the diffraction gratings and integration with other parts of the system and/or use cases of the diffraction gratings themselves. Some methods of manufacture for diffraction gratings include using semiconductor processes to etch and/or lithographically define (e.g., via nanoimprint lithography, direct ultraviolet (UV) lithography, grayscale lithography, and/or the like) the periodic structures of the grating on a substrate. Such gratings are referred to herein as "surface-relief" diffraction gratings. For example, a subtractive grating can be made by ruling grooves into a substrate with a stylus (e.g., diamond stylus) or with other material-dependent semiconductor manufacturing techniques. Other methods of manufacture for diffraction gratings, such as holography, use multiple coherent light sources interfered on a photosensitive material to define the periodic structures of the grating. Holographic gratings can have significantly higher efficiencies than other grating types when the incident light satisfies the Bragg condition. For example, the simplest holographic diffraction grating is typically formed by an interference-fringe field of two laser beams whose standing wave pattern is exposed to substrate, which is then processed to form a pattern of lines, typically having a sinusoidal cross-section. The substrate in or on which a diffraction grating is formed may include dielectric, semimetal, semiconductor, metal, crystalline, glass, organic, or inorganic material, or an applicable combination of these.

Regardless of type, diffraction gratings reflect incident light at an angle that is dependent upon the angle of incidence of the light and the wavelength of the light. In the present embodiment, only a small portion of the incident laser light beams 430 are reflected off of the holographic diffraction grating 416, while the remainder of the light is output through the primary output surface of the exit window 414. In some embodiments, the holographic diffraction grating 416 is a volume phase holographic grating (VPHG). In some embodiments, the holographic diffraction grating 416 includes a thick volume holographic film (e.g., about 20 to 200 µm thick with a refractive index modulation of about 0.001 to about 0.1) that operates in the reflection mode and that provides a narrow band response for each of one or more desired resonant wavelengths, with separate gratings being included in the thick volume holographic film for each resonant wavelength. In some embodiments, the holographic diffraction grating 416 includes a thin volume holographic film (e.g., about 1 µm thick with a refractive index modulation of about 0.001) that operates in either the reflective mode or the transmissive mode, depending on the variability of the source parameters in wavelength and divergence and the desired sensitivity for these parameters, with separate gratings being included in the thin volume holographic film for each resonant wavelength. While the diffracting elements of the holographic diffraction grating 416 are shown to extend in a direction parallel with that of the primary direction of propagation of the laser light beams 430, it should be understood that these elements may be tilted or may include one or more surfaces that are tilted with respect to the primary direction of propagation of laser light beams, as required to achieve a desired direction of reflection/diffraction of a portion of the laser light beams.

In some embodiments, reflective coatings may be applied to one or more of the top surface, the bottom surface, or the left side wall surface of the exit window 414 in order to increase the amount of internal reflection that occurs within the exit window 414, which may advantageously increase the amount of light 432 that is output through the right side wall of the exit window 414 toward the PD 410. For example, the addition of reflective coatings on these surfaces of the exit window 414 may redirect any portion of light that might otherwise break from the total internal reflection (TIR) condition of the diffraction grating 416, which could occur due to the angle of a portion of the incident light on the diffraction grating 416 being less than the critical angle of the diffraction grating 416, or due to contact between the exit window 414 and another component (e.g., adhesive, the substrate 401, the enclosure 403, etc.).

In some embodiments, one or more portions of the holographic diffraction grating 416 may be configured to have respective resonant wavelengths corresponding to one or more of the colors of the laser light beams 430. For example, a first portion of the holographic diffraction grating 416 that is in the light path of the green laser light beam 430 may be configured with a first peak resonance wavelength that matches the wavelength of the green laser light beam 430 (e.g., between about 510 and 570 nm), a second portion of the holographic diffraction grating 416 that is in the light path of the blue laser light beam 430 may be configured with a second peak resonance wavelength that matches the wavelength of the blue laser light beam 430 (e.g., between about 360 and 480 nm), and a third portion of the holographic diffraction grating 416 that is in the light path of the red laser light beam 430 may be configured with a third peak resonance wavelength that matches the wavelength of the red laser light beam 430 (e.g., between about 650 and 670 nm). By tailoring the holographic diffraction grating 416 to be divided into portions along its length having respectively different resonant wavelengths, each corresponding to the wavelength of a different one of the laser light beams 430 in this way, improvements in responsivity of the PD 410 and reduction in path length to the PD 410 may be achieved. For example, by tailoring the diffraction grating 416 specifically for each color, the amount of diffracted light that reaches the PD 410 can be maximized, or otherwise increased, as diffracting the light at the most efficient angle minimizes losses in the optical path. For example, by providing the diffraction grating 416 with color-specific portions, the number of TIR bounces within the exit window 414 may be reduced, or the laser light beams 430 may be better directed toward the PD 410 so that all or substantially all of the diffracted light reaches the PD 410.

In some embodiments, one or more optical elements, such as a collimating lens 433, may be disposed between the right side wall of the exit window 414 and the PD 410 to focus the light 432 onto the PD 410. In some embodiments, such optical elements may additionally or alternatively include a focusing lens, a geometric optic, or a metasurface optic that is printed on the exit face of the right side wall of the exit window 414.

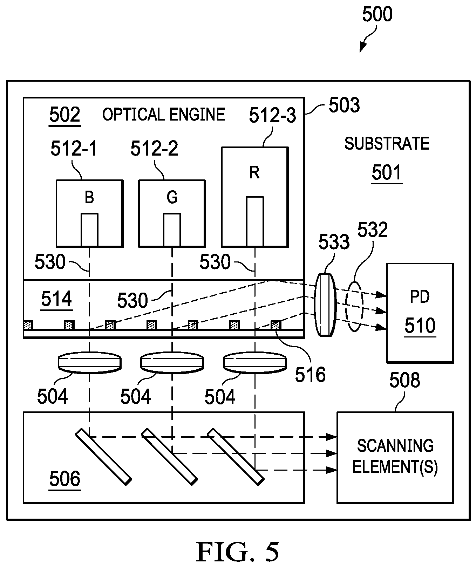

FIG. 5 shows an illustrative laser projector 500 that uses a reflective surface-relief diffraction grating to redirect light toward a photodetector, which may be a photodiode. Specifically, the laser projector 500 includes an optical engine 502, collimating lenses 504, a dichroic filter/combiner 506, one or more scanning elements 508, and a PD 510, which are all disposed on a substrate 501. The substrate 501 may be a PCB, for example.

Various aspects of the optical engine 502, enclosure 503, collimating lenses 504, dichroic filter/combiner 506, scanning elements 508, PD 510, laser sources 512, exit window 514, and laser light beams 530 of the laser projector 500 are substantially the same as those of corresponding elements of the laser projector 400 of FIG. 4, and some of the previous description of such elements is not repeated here for the sake of brevity.

A distinction between the laser projector 500 and the laser projector 400 of FIG. 4 is the use of a surface-relief diffraction grating 516 in or on the exit window 514, rather than a holographic diffraction grating. The reflective surface-relief diffraction grating 516 includes a repeating pattern of relief structures at a surface (e.g., the primary output surface of the exit window 514), where incident light is reflected off of the surface-relief diffraction grating at an angle that is dependent upon the angle of incidence of the light and the wavelength of the light. In some embodiments, the reflective surface-relief diffraction grating 516 may be a blazed reflective surface-relief diffraction grating. In some embodiments, the reflective surface-relief diffraction grating 516 may include fine pitch binary gratings with low feature heights. In some embodiments, the grating pitch for the reflective surface-relief diffraction grating 516 is between 320 nm and 440 nm and the grating height is about 2-300 nm.

The binary grating pitch is selected based on the input wavelengths of the laser light beams 530 and the index of refraction of the exit window 514. For example, for red, green, and blue input wavelengths (e.g., 610-660nm, 520-550nm, and 440-470 nm, respectively) and an exit window index of refraction of about 1.51, the pitch of the binary gratings may be equal to about 440 nm, targeting the blue input wavelength to be at TIR. The grating pitch increases as the index of refraction of the exit window 514 increases and decreases as the index of refraction decreases. The height of each of the gratings is dependent on the material used for the grating. For example, for direct etching or nanoimprint lithography of a glass exit window 514 having an index of refraction of about 1.51, the binary gratings may each have a height of about 20 nm to achieve 1% coupling efficiency for blue wavelengths and 0.5% coupling efficiency for red wavelengths. As another example, for direct etching or nanoimprint lithography of a glass exit window 514 having an index of refraction of about 1.51, the binary gratings may each have a height of about 100 nm to achieve 8% coupling efficiency for blue wavelengths. As another example, for direct etching or nanoimprint lithography of a glass exit window 514 having an index of refraction of about 1.51, the binary gratings may each have a height of about 200 nm to achieve around 2% coupling efficiency for blue wavelengths and around 2% coupling efficiency for red wavelengths. It should be noted that in some embodiments, rather than using a reflective surface-relief diffraction grating, a transmissive surface-relief diffraction grating having a very low fill factor is used to achieve similarly low coupling efficiencies while also breaking the plus-minus symmetry of the grating. In the present example, due to the low input wavelength coupling efficiencies of the reflective surface-relief diffraction grating 516, only a small portion of the incident laser light beams 530 are reflected off of the reflective surface-relief diffraction grating 516, while the remainder of the light is output through the primary output surface of the exit window 514.

The reflective surface-relief diffraction grating 516, is dimensioned to redirect (e.g., via diffraction) light 532 (sometimes referred to herein as "redirected laser light 532), which is a portion of the laser light beams 530, through a side wall (e.g., the right side wall, with respect to the orientation depicted in FIG. 5 of the exit window 514, toward a PD 510 that is disposed near the right side wall and in the optical path of some or all of the light redirected through. The PD 510 measures the intensity of the redirected laser light 532. The measured light intensity is then provided to a controller or microprocessor that is coupled to the PD 510, which calculates, monitors, and adjusts the laser output power of the optical engine 502, and which may limit a maximum laser output power of the optical engine 502 based on the calculated laser output power of the optical engine 502.

In some embodiments, reflective coatings may be applied to one or more of the top surface, the bottom surface, or the left side wall surface of the exit window 514 in order to increase the amount of internal reflection that occurs within the exit window 514, which may advantageously increase the amount of light 532 that is output through the right side wall of the exit window 514 toward the PD 510. For example, the addition of reflective coatings on these surfaces of the exit window 514 may redirect any portion of light that might otherwise break from the total internal reflection (TIR) condition of the diffraction grating 516, which could occur due to the angle of a portion of the incident light on the diffraction grating 516 being less than the critical angle of the diffraction grating 516, or due to contact between the exit window 514 and another component (e.g., adhesive, the substrate 501, the enclosure 503, etc.).

In some embodiments, one or more portions of the reflective surface-relief diffraction grating 516 may be configured to have respective resonant wavelengths corresponding to one or more of the colors of the laser light beams 530. For example, a first portion of the reflective surface-relief diffraction grating 516 that is in the light path of the green laser light beam 530 may be configured with a first peak resonance wavelength that matches the wavelength of the green laser light beam 530 (e.g., between about 510 and 570 nm), a second portion of the reflective surface-relief diffraction grating 416 that is in the light path of the blue laser light beam 530 may be configured with a second peak resonance wavelength that matches the wavelength of the blue laser light beam 530 (e.g., between about 360 and 480 nm), and a third portion of the reflective surface-relief diffraction grating 516 that is in the light path of the red laser light beam 530 may be configured with a third peak resonance wavelength that matches the wavelength of the red laser light beam 530 (e.g., between about 650 and 670 nm). By tailoring the reflective surface-relief diffraction grating 516 to be divided into portions along its length having respectively different resonant wavelengths, each corresponding to the wavelength of a different one of the laser light beams 530 in this way, improvements in responsivity of the PD 510 and reduction in path length to the PD 510 may be achieved. For example, by tailoring the reflective surface-relief diffraction grating 516 specifically for each color, the amount of diffracted light that reaches the PD 510 can be maximized, or otherwise increased, as diffracting the light at the most efficient angle minimizes losses in the optical path. For example, by providing the reflective surface-relief diffraction grating 516 with color-specific portions, the number of TIR bounces within the exit window 514 may be reduced, or the laser light beams 530 may be better directed toward the PD 510 so that all or substantially all of the diffracted light reaches the PD 510.

In some embodiments, one or more optical elements, such as a collimating lens 533, may be disposed between the right side wall of the exit window 514 and the PD 510 to focus the light 532 onto the PD 510. In some embodiments, such optical elements may additionally or alternatively include a focusing lens, a geometric optic, or a metasurface optic that is printed on the exit face of the right side wall of the exit window 514.

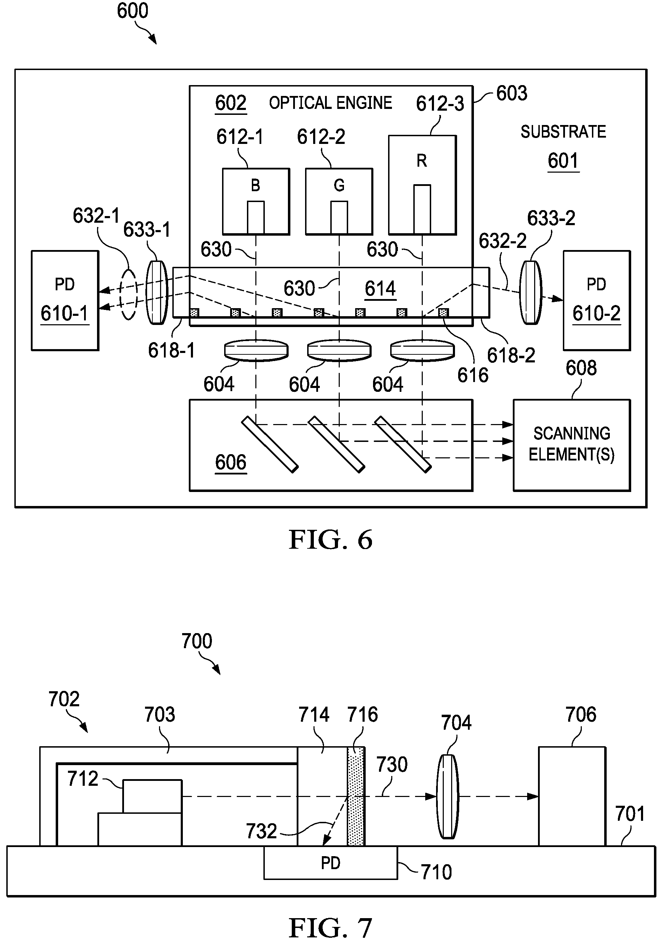

FIG. 6 shows an illustrative laser projector 600 that uses a reflective surface-relief diffraction grating to redirect light toward two photodetectors, which may be photodiodes. Specifically, the laser projector 600 includes an optical engine 602, an enclosure 603 having an exit window 614 and a reflective diffraction grating 616, collimating lenses 604, a dichroic filter/combiner 606, one or more scanning elements 608, and two PDs 610 (i.e., a left PD 610-1 and a right PD 610-2, with respect to the orientation shown in FIG. 6), which are all disposed on a substrate 601. The substrate 601 may be a PCB, for example. It should be noted that, while a reflective surface-relief diffraction grating is shown in the present example, another type of diffraction grating, such as a holographic diffraction grating, could instead be disposed at the primary output surface of the exit window 614 in other embodiments.

Various aspects of the optical engine 602, enclosure 603, collimating lenses 604, dichroic filter/combiner 606, scanning elements 608, PDs 610, laser sources 612, exit window 614, and laser light beams 630 of the laser projector 600 are substantially the same as those of corresponding elements of the laser projector 400 of FIG. 4, and some of the previous description of such elements is not repeated here for the sake of brevity.

Two PDs 610-1 and 610-2 are disposed across the from the side walls of exit window 614, such that light 632, which is a portion of the laser light beams 630 output by the laser sources 612, is redirected through the side walls of the exit window 614 toward the PDs 610-1 and 610-2. The reflective diffraction grating 616 may be a binary diffraction grating in the present example and may redirect the light beams left and right toward both side walls of the exit window 614 and, thereby, toward both PDs 610. In the present example, dichroic filters 618-1 and 618-2 are disposed on surfaces of the left and right side walls, respectively, of the exit window 614. The dichroic filter 618-1 is disposed on the left side wall of the exit window 614 and is substantially transmissive (e.g., with a transmissivity of greater than 80% [)of light in one or more wavebands that collectively include the wavelength of the blue laser light beam 630 output by the blue laser source 612-1 and that includes the wavelength of the green laser light beam 630 output by the green laser source 612-2, and that is substantially reflective (e.g., with a reflectivity of greater than 80% ) of light in a waveband that includes the wavelength of the red laser light beam 630 output by the red laser source 612-3. The dichroic filter 618-2 is disposed on the right side wall of the exit window 614 and is substantially transmissive (e.g., with a transmissivity of greater than 80% )of light in a waveband that includes the wavelength of the red laser light beam 630 output by the red laser source 612-3, and substantially reflective (e.g., with a reflectivity of greater than 80% ) of light in one or more wavebands that collectively include the wavelength of the blue laser light beam 630 output by the blue laser source 612-1 and that includes the wavelength of the green laser light beam 630 output by the green laser source 612-2. In this way, the PD 610-1 primarily receives the reflected portions 632-1 of the green and blue laser light beams, while the PD 610-2 receives the reflected portions 632-2 of the red laser light beam. Accordingly, the PD 610-1 measures the combined intensity of the blue and green laser light beams, while the PD 610-2 measures the intensity of the red laser light beam. The measured light intensities are then provided to a controller or microprocessor that is coupled to the PDs 610-1 and 610-2, which calculates and monitors the laser output power of the optical engine 602, and which may limit a maximum laser output power of the optical engine 602 based on the calculated laser output power of the optical engine 602. For example, when measuring the brightness intensity of individual colors of the laser light beams 630, the laser sources 612 that do not correspond to the color of light being measured are turned off and the laser source 612 that does correspond to the color of light being measured remains on, and the laser projector 600 generally cannot display image data while these measurements are taken. By providing multiple photodiodes 610 and color filters that allow the PD 610-1 to measure blue and green light while the PD 610-2 measures red light, the amount of off-time required to measure brightness intensities of the laser light beams 630 is advantageously reduced, since red and blue or red and green brightness intensities can be measured simultaneously. Further, the PD 610-1 may be tuned to be responsive to the wavelength of the red laser light beam and the PD 610-2 may be tuned to be responsive to the wavelengths of the blue and green laser light beams, which allows the PDs 610 to accurately measure brightness intensities with less received light (e.g., advantageously reducing the portions of the light beams 630 that need to be redirected to the PDs 610) and/or reducing the amount of time required for the PDs 610 to accurately obtain respective brightness intensity measurements.

While dichroic filters 618 are used to limit the color of light that can pass to particular PDs 610 in the present example, it should be understood that in alternative embodiments, other types of filters, such as polarization filters, may be used in place of the dichroic filters 618. As another alternative embodiment, the dichroic filters 618 may be omitted, such that the PDs 610 receive and measure all detectable wavelengths of light reflected from the reflective surface-relief diffraction grating 616.

In some embodiments, reflective coatings may be applied to one or more of the top surface or the bottom surface of the exit window 614 in order to increase the amount of internal reflection that occurs within the exit window 614, which may advantageously increase the amount of light 632 that is output through the side walls of the exit window 614 toward the PDs 610.

In some embodiments, one or more portions of the reflective surface-relief diffraction grating 616 may be configured to have respective resonant wavelengths corresponding to one or more of the colors of the laser light beams 630. For example, a first portion of the reflective surface-relief diffraction grating 616 that is in the light path of the green laser light beam 630 may be configured with a first peak resonance wavelength that matches the wavelength of the green laser light beam 630 (e.g., between about 510 and 570 nm), a second portion of the reflective surface-relief diffraction grating 616 that is in the light path of the blue laser light beam 630 may be configured with a second peak resonance wavelength that matches the wavelength of the blue laser light beam 630 (e.g., between about 360 and 480 nm), and a third portion of the reflective surface-relief diffraction grating 616 that is in the light path of the red laser light beam 630 may be configured with a third peak resonance wavelength that matches the wavelength of the red laser light beam 630 (e.g., between about 650 and 670 nm). By tailoring the reflective surface-relief diffraction grating 616 to be divided into portions along its length having respectively different resonant wavelengths, each corresponding to the wavelength of a different one of the laser light beams 630 in this way, improvements in responsivity of the PDs 610 and reduction in path length to the PDs 610 may be achieved. For example, by tailoring the diffraction grating 616 specifically for each color, the amount of diffracted light that reaches the PDs 610 can be maximized, or otherwise increased, as diffracting the light at the most efficient angle minimizes losses in the optical path. For example, by providing the diffraction grating 616 with color-specific portions, the number of TIR bounces within the exit window 614 may be reduced, or the laser light beams 630 may be better directed toward the PDs 610 so that all or substantially all of the diffracted light reaches the PDs 610.

In some embodiments, one or more optical elements, such as collimating lenses 633-1 and 633-2, which may be disposed between the side walls of the exit window 614 and the PDs 610 to focus the light 632 onto the PDs 610. In some embodiments, such optical elements may additionally or alternatively include focusing lenses, geometric optics, or metasurface optics that are printed on the exit faces of the left and right side walls of the exit window 614.

FIG. 7 shows an illustrative cross-sectional side view of a laser projector 700 that uses a reflective surface-relief diffraction grating to redirect light toward a photodetector that is embedded in a substrate, where the photodetector may be a photodiode. The laser projector 700 includes an optical engine 702 having an enclosure 703, laser sources 712, and an exit window 714, a PD 710, collimating lenses 704, a dichroic filter/combiner 706, and one or more scanning elements (not shown). While a top-down view of the laser projector 700 is not provided, it should be understood that the arrangement of the laser projector 700 may be substantially similar to that of the laser projector 500 shown in FIG. 5, apart from the placement of the PD, and some of the description of the components of FIG. 7 having corresponding components in the laser projector 500 of FIG. 5 is not repeated here for the sake of brevity.

In the present example, rather than being placed on a surface of the substrate 701, a PD 710 is embedded in the substrate 701 below the exit window 714, such that a top surface of the PD 701 is substantially planar with a top surface of the substrate 701. The reflective surface-relief diffraction grating 716 may be configured to redirect the reflected portion 732 of the laser light beam 730 downward, toward PD 710 through the floor of the exit window 714. In some embodiments, a reflective coating may be applied to one or more of the top surface, left side wall, or right side wall of the exit window 714 in order to increase the amount of light 732 that is redirected toward the PD 710. In some embodiments, the bottom surface of the exit window 714 may be attached to the PD 710 with an adhesive that is index-matched to the refractive indices of the PD 710 and the bottom surface of the exit window 714. As described above, in some embodiments, one or more portions of the reflective surface-relief diffraction grating 716 may be configured to have respective resonant wavelengths corresponding to one or more of the colors of the laser light beams 730. In some embodiments, multiple PDs 710 may be disposed on the second side of the substrate 701, where each PD 710 is disposed directly below and vertically overlapping the optical path of a respectively different laser light beam 730. It should be noted that, while a reflective surface-relief diffraction grating is shown in the present example, another type of diffraction grating, such as a holographic diffraction grating, could instead be disposed at the primary output surface of the exit window 714 in other embodiments.

By embedding the PD 710 in the substrate 701, the footprint of the laser projector 700 may be comparatively reduced with respect to embodiments in which the PD is disposed on the surface of the substrate 701, though at the cost of somewhat increased manufacturing complexity and limitations (e.g., potentially limiting the size, type, material, and/or responsivity of the PDs, the methods of electrical connection, and/or applicable substrate types).

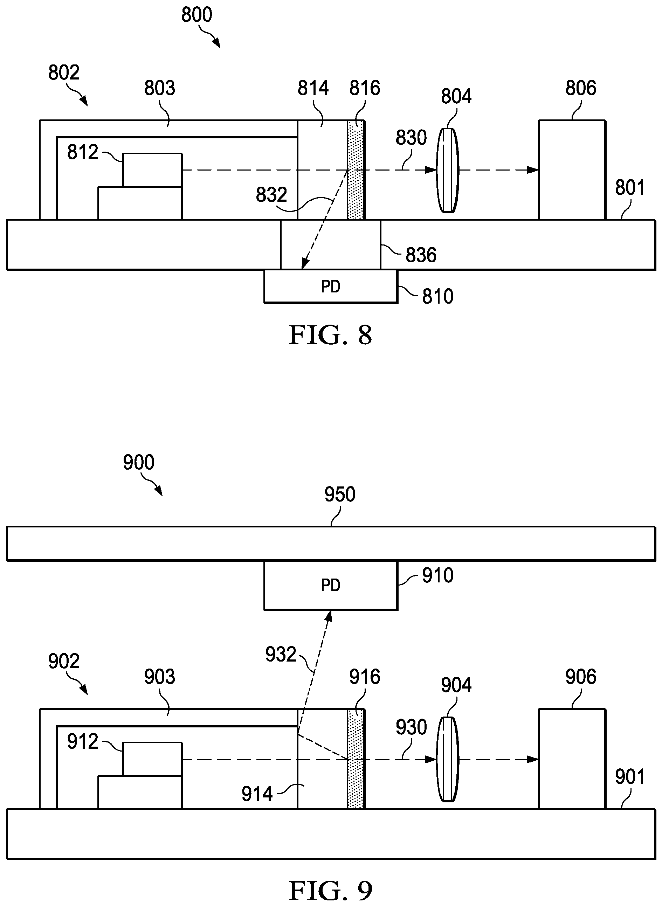

FIG. 8 shows an illustrative cross-sectional side view of a laser projector 800 that uses a reflective surface-relief diffraction grating to redirect light toward a photodetector that is disposed on an opposite side of a substrate from the side on which an optical engine of the laser diode 800 is disposed, where the photodetector may be a photodiode. The laser projector 800 includes an optical engine 802 having an enclosure 803, laser sources 812, and an exit window 814, a PD 810, collimating lenses 804, a dichroic filter/combiner 806, and one or more scanning elements (not shown). While a top-down view of the laser projector 800 is not provided, it should be understood that the arrangement of the laser projector 800 may be substantially similar to that of the laser projector 500 shown in FIG. 5, apart from the placement of the PD, and some of the description of the components of FIG. 8 having corresponding components in the laser projector 500 of FIG. 5 is not repeated here for the sake of brevity.

In the present example, rather than being placed on a surface of the substrate 801, a PD 810 is disposed on a second side of the substrate 801 that is opposite the first side of the substrate on which the optical engine 802 is disposed and is disposed directly below the exit window 814. The substrate 801 includes an aperture (e.g., pass-through) disposed between the PD 810 and the bottom surface of the exit window 814. The reflective surface-relief diffraction grating 816 may be configured to redirect the reflected portion 832 of the laser light beam 830 downward, toward PD 810 through the floor of the exit window 814 and through the aperture 801. In some embodiments, a reflective coating may be applied to one or more of the top surface, left side wall, or right side wall of the exit window 814 in order to increase the amount of light 832 that is redirected toward the PD 810. As described above, in some embodiments, one or more portions of the reflective surface-relief diffraction grating 816 may be configured to have respective resonant wavelengths corresponding to one or more of the colors of the laser light beams 830. In some embodiments, multiple PDs 810 may be disposed on the second side of the substrate 801, where each PD 810 is disposed directly below and vertically overlapping the optical path of a respectively different laser light beam 830. It should be noted that, while a reflective surface-relief diffraction grating is shown in the present example, another type of diffraction grating, such as a holographic diffraction grating, could instead be disposed at the primary output surface of the exit window 814 in other embodiments.

By disposing the PD 810 on the opposite side of the substrate 801 from the optical engine 802, the footprint of the laser projector 800 may be comparatively reduced with respect to embodiments in which the PD is disposed on the same surface of the substrate 801 as the optical engine 802, though at the cost of somewhat increased manufacturing complexity and limitations (e.g., potentially limiting the size, type, material, and/or responsivity of the PDs, the methods of electrical connection, and/or applicable substrate types).

FIG. 9 shows an illustrative cross-sectional side view of a laser projector 900 that uses a reflective diffraction grating to redirect light toward a photodetector that is disposed on a second substrate that is located above the substrate on which the optical engine of the laser projector 900 is disposed, where the photodetector may be a photodiode. The laser projector 900 includes a first substrate 901 on which an optical engine 902 having an enclosure 903, laser sources 912, and an exit window 914, collimating lenses 904, a dichroic filter/combiner 906, and one or more scanning elements (not shown) are disposed, and that includes a second substrate 950 on which at least a PD 910 is disposed. While a top-down view of the laser projector 900 is not provided, it should be understood that the arrangement of the laser projector 900 may be substantially similar to that of the laser projector 500 shown in FIG. 5, apart from the placement of the PD, and some of the description of the components of FIG. 9 having corresponding components in the laser projector of FIG. 5 is not repeated here for the sake of brevity.

In the present example, rather than being placed on a surface of the first substrate 901, a PD 910 is disposed on a second substrate 950 that is located above the first substrate 901 on which the optical engine 902 is disposed and is disposed directly above the exit window 914. The reflective surface-relief diffraction grating 916 may be configured to redirect the reflected portion 932 of the laser light beam 930 upward, toward PD 910 through the top surface of the exit window 914. In some embodiments, a reflective coating may be applied to one or more of the bottom surface, left side wall, or right side wall of the exit window 914 in order to increase the amount of light 932 that is redirected toward the PD 910. As described above, in some embodiments, one or more portions of the reflective surface-relief diffraction grating 916 may be configured to have respective resonant wavelengths corresponding to one or more of the colors of the laser light beams 930. In some embodiments, multiple PDs 910 may be disposed on the second substrate 950, where each PD 910 is disposed directly above and vertically overlapping the optical path of a respectively different laser light beam 930. It should be noted that, while a reflective surface-relief diffraction grating is shown in the present example, another type of diffraction grating, such as a holographic diffraction grating, could instead be disposed at the primary output surface of the exit window 914 in other embodiments.

By disposing the PD 910 on the opposite side of the substrate 901 from the optical engine 902, the footprint of the laser projector 900 on the first substrate 901 may be comparatively reduced with respect to embodiments in which the PD is disposed on the same substrate 901 as the optical engine 902, may allow a wider variety of PDs to be used for laser output power intensity monitoring due to fewer space, material compatibility, and electrical connection constraints, and may provide additional room for optical components such as collimating or focusing optics (e.g., in the optical path between the PD 910 and the exit window 914), though this arrangement requires the addition of the second substrate 950.

While reflective diffraction gratings have been provided in the examples of FIGS. 4-9, it should be understood that transmissive diffraction gratings may be used in place of any of the diffraction gratings 416, 516, 616, 716, 816, and 916 of FIGS. 4-9, but would be disposed on the optical input surface of the corresponding exit window, rather than the optical output surface.

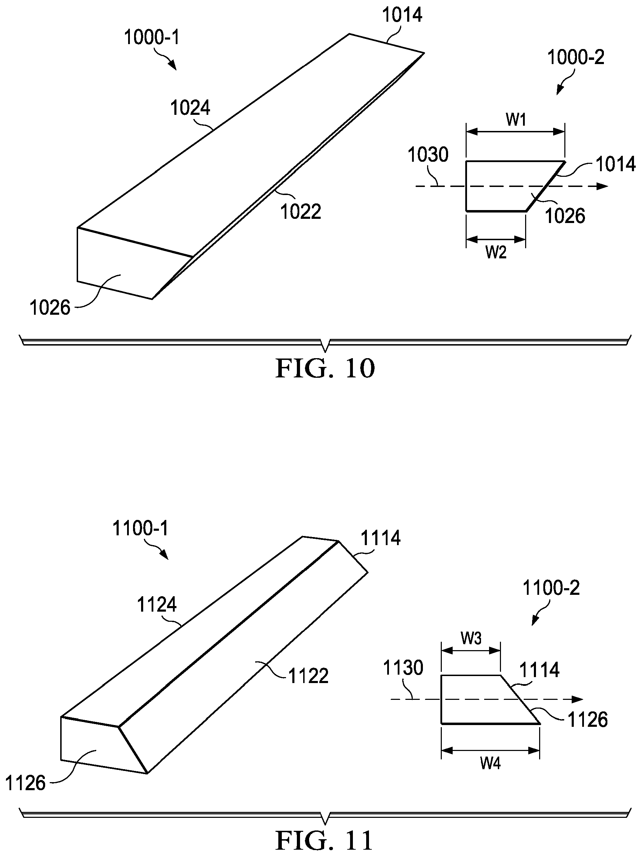

It should be understood that the shape of any of the exit windows 414, 514, 614, 714, 814, and 914 of FIGS. 4-9 may not be limited to that of a rectangular prism. In some embodiments the primary output surface of the exit window may be slanted, as shown in FIGS. 10-12, such that the plane of the primary output surface of the exit window is not orthogonal with the direction of any of the light beams output by the laser diodes.

For example, FIG. 10 shows a perspective view 1000-1 and a side view 1000-2 of an exit window 1014 having a primary output surface 1022 that defines a plane that is not orthogonal with the direction of light beams 1030 output by the laser diodes and that is not parallel with the plane defined by the rear surface 1024 where the primary output surface 1022 meets the bottom surface of the exit window 1014 to form an obtuse angle. That is, the exit window 1014 is slanted upward and outward, with respect to the orientation depicted in the side view 1000-2, from the bottom surface of the exit window 1014 to the top surface of the exit window 1014. For example, the primary output surface 1022 is slanted with respect to the primary input surface of the exit window 1014. As shown in the side view 1000-2, the side surfaces of the exit window 1014 are shaped as right trapezoids. The width W1 of the top surface of the exit window 1014 is greater than the width W2 of the bottom surface of the exit window 1014. In some embodiments, one or more edges at which surfaces of the exit window 1014 meet may be chamfered or curved.

As another example, FIG. 11 shows a perspective view 1100-1 and a side view 1100-2 of an exit window 1114 having a primary output surface 1122 that defines a plane that is not orthogonal with the direction of light beams 1130 output by the laser diodes and that is not parallel with the plane defined by the rear surface 1124, where the primary output surface 1122 meets the bottom surface of the exit window 1114 to form an acute angle. That is, the exit window 1114 is slanted downward and outward, with respect to the orientation depicted in the side view 1100-2, from the top surface of the exit window 1114 to the bottom surface of the exit window 1114. For example, the primary output surface 1122 is slanted with respect to the primary input surface of the exit window 1114. As shown in the side view 1100-2, the side surfaces of the exit window 1114 are shaped as right trapezoids. The width W3 of the top surface of the exit window 1114 is less than the width W4 of the bottom surface of the exit window 1114. In some embodiments, one or more edges at which surfaces of the exit window 1114 meet may be chamfered or curved.

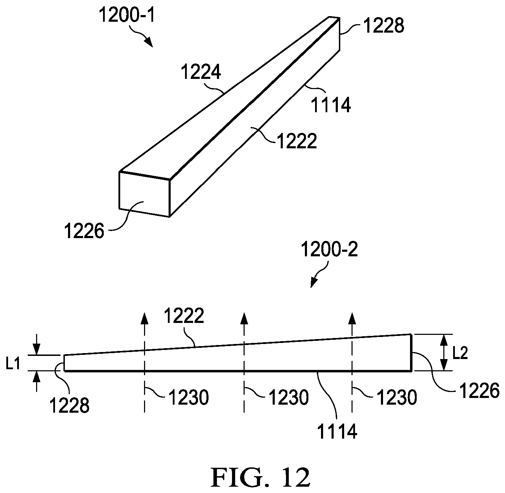

As another example, FIG. 12 shows a perspective view 1200-1 and a top-down view 1200-2 of an exit window 1214 having a primary output surface 1222 that defines a plane that is not orthogonal with the direction of light beams 1230 output by the laser diodes and that is not parallel with the plane defined by the rear surface 1224, where the primary output surface 1222 meets a first side surface 1226 (i.e., a right side surface, with respect to the orientation depicted in the top-down view 1200-2) of the exit window 1214 to form an acute angle and meets a second side surface 1228 (i.e., a left side surface, with respect to the orientation depicted in the top-down view 1200-2) of the exit window 1214 to form an obtuse angle. That is, the exit window 1214 is slanted rightward and outward, with respect to the orientation depicted in the top-down view 1200-2, from the second side surface 1228 of the exit window 1214 to the first side surface 1226 of the exit window 1214. For example, the primary output surface 1222 is slanted with respect to the primary input surface of the exit window 1214. The length L1 of the side surface1228 is less than the length L2 of the side surface 1226. In some embodiments, one or more edges at which surfaces of the exit window 1214 meet may be chamfered or curved.

As another example, the exit window may maintain a cuboidal shape and may, with respect to the orientation of the exit window shown in FIGS. 4-6, be rotated (e.g., in the plane of the page) clockwise or counterclockwise about an axis that extends through center points of the top and bottom surfaces of the exit window (e.g., by about .1 to 15 degrees), without rotating the rest of the enclosure. Additionally or alternatively, the exit window may be rotated about its long axis by about .1 to 10 degrees. By changing the orientation of the exit window in this way, the primary input surface of the exit window (i.e., the surface that first receives light beams from the laser sources and that is opposite from the primary output surface) is non-orthogonal with the primary direction of propagation of the light beams output from the laser sources.

By arranging the primary output surface of the exit window to not be orthogonal to the primary direction of propagation of the light beams output from the laser sources, as shown in the various examples of FIGS. 10-12, the amount of optical feedback into the laser diodes of the optical engine is advantageously reduced. It should be noted that such optical feedback may be caused by the light beams output by the laser diodes being redirected by the diffraction grating that is disposed on or integrated within the exit window.

Note that not all of the activities or elements described above in the general description are required, that a portion of a specific activity or device may not be required, and that one or more further activities may be performed, or elements included, in addition to those described. Still further, the order in which activities are listed is not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the particular embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular embodiments disclosed above may be altered or modified and all such variations are considered within the scope of the disclosed subject matter. Accordingly, the protection sought herein is as set forth in the claims below.

## Claims

1. A laser projector (400, 500, 600, 700, 800, 900) comprising:
at least one photodetector (410, 510, 610-1, 610-2, 710, 810, 910) configured to measure light intensity; and
an optical engine (402, 502, 602, 702, 802, 902) comprising:
at least one laser source (412-1, 412-2, 412-3, 512-1, 512-2, 512-3, 612-1, 612-2, 612-3, 712, 812, 912) configured to output a light beam;
an exit window (414, 514, 614, 714, 814, 914) disposed in an optical path of the light beam output by the laser source, wherein the exit window receives the light beam via a primary input surface of the exit window;
**characterized in that**
the optical engine comprises a diffraction grating (416, 516, 616, 716, 816, 916) disposed on a primary output surface of the exit window,
wherein the diffraction grating is configured to redirect a portion of the light beam toward the photodetector through at least one surface of the exit window that extends between the primary input surface and the primary output surface.

2. The laser projector of claim 1, further comprising:
an enclosure that surrounds the laser source and that includes the exit window.

3. The laser projector of claim 1, wherein the diffraction grating is a holographic diffraction grating.

4. The laser projector of claim 1, wherein the diffraction grating is a surface-relief diffraction grating.

5. The laser projector of any of claims 1 to 4, wherein at least a portion of the diffraction grating that overlaps the optical path of the light beam has a resonant wavelength corresponding to the wavelength of the light beam.

6. The laser projector of any of claims 1 to 5, wherein the optical engine is disposed on a surface of a substrate, wherein the photodetector is disposed across from a side wall of the exit window, wherein the side wall is adjacent to the primary output surface and defines a plane that is perpendicular to the surface of the substrate, and wherein the diffraction grating redirects the portion of the light beam toward the photodetector through the side wall of the exit window.

7. The laser projector of any of claims 1 to 5, wherein the optical engine is disposed on a substrate, the photodetector is disposed directly beneath the exit window and directly beneath the optical path of the light beam, and the diffraction grating redirects the portion of the light beam toward the photodetector through a bottom surface of the exit window that faces the substrate.

8. The laser projector of claim 7, wherein the photodetector is embedded in the substrate.

9. The laser projector of claim 7, wherein the optical engine is disposed on a first side of the substrate, the photodetector is disposed on a second side of the substrate that is opposite the first side, and the diffraction grating redirects the portion of the light beam toward the photodetector through the bottom surface of the exit window and through an aperture that extends through the substrate from the first side to the second side.

10. The laser projector of any of claims 1 to 5, wherein the optical engine is disposed on a first substrate, the photodetector is disposed on a second substrate that is disposed over the first substrate such that the photodetector is disposed directly over the exit window and the optical path of the light beam, and the diffraction grating redirects the portion of the light beam toward the photodetector through a top surface of the exit window that faces toward the second substrate and faces away from the first substrate.

11. The laser projector of any of claims 1 to 5 wherein the primary output surface of the exit window is slanted with respect to the primary input surface of the exit window, wherein the light beam is incident on the primary input surface of the exit window.

12. The laser projector of any of the preceding claims, wherein the optical engine comprises:
a plurality of laser sources configured to output a plurality of light beams;
an enclosure that surrounds the plurality of laser sources, the enclosure having the exit window disposed in each optical path of the plurality of light beams output by the plurality of laser sources, wherein the diffraction grating redirects a portion of each of the plurality of light beams toward the at least one photodetector.

13. The laser projector of claim 12, further comprising a collimating lens between the exit window and the at least one photodetector.

14. The laser projector of claim 12 or 13, wherein the diffraction grating comprises:
a first portion having a first resonant wavelength that corresponds to a first wavelength of a first light beam of the plurality of light beams, where the first portion overlaps a first optical path of the first light beam; and
a second portion having a second resonant wavelength that corresponds to a second wavelength of a second light beam of the plurality of light beams, where the second portion overlaps a second optical path of the second light beam.

15. The laser projector of any of claims 12 to 14, wherein the optical engine is disposed on a surface of a substrate, the at least one photodetector comprises a first photodetector that is disposed across from a first side wall of the exit window of the enclosure, the first side wall is adjacent to the primary output surface and defines a plane that is perpendicular to the surface of the substrate, and the diffraction grating redirects a first portion of at least a first light beam of the plurality of light beams toward the first photodetector through the first side wall of the exit window, wherein the at least one photodetector further comprises a second photodetector that is disposed across from a second side wall of the exit window of the enclosure, the second side wall is opposite the first side wall, and the diffraction grating redirects a second portion of at least a second light beam of the plurality of light beams toward, the second photodetector through the second side wall of the exit window.

## Patentansprüche

1. Laserprojektor (400, 500, 600, 700, 800, 900), umfassend:
mindestens einen Photodetektor (410, 510, 610-1, 610-2, 710, 810, 910), der konfiguriert ist, um eine Lichtintensität zu messen; und
eine optische Maschine (402, 502, 602, 702, 802, 902), umfassend:
mindestens eine Laserquelle (412-1, 412-2, 412-3, 512-1, 512-2, 512-3, 612-1, 612-2, 612-3, 712, 812, 912), die konfiguriert ist, um einen Lichtstrahl auszugeben;
ein Austrittsfenster (414, 514, 614, 714, 814, 914), das in einem optischen Pfad des von der Laserquelle ausgegebenen Lichtstrahls angeordnet ist, wobei das Austrittsfenster den Lichtstrahl über eine primäre Eingangsfläche des Austrittsfensters empfängt;
**dadurch gekennzeichnet, dass**
die optische Maschine ein Beugungsgitter (416, 516, 616, 716, 816, 916) umfasst, das auf einer primären Ausgangsfläche des Austrittsfensters angeordnet ist,
wobei das Beugungsgitter konfiguriert ist, um einen Teil des Lichtstrahls durch mindestens eine Fläche des Austrittsfensters, die sich zwischen der primären Eingangsfläche und der primären Ausgangsfläche erstreckt, in Richtung des Photodetektors umzulenken.

2. Laserprojektor nach Anspruch 1, ferner umfassend:
eine Umhüllung, welche die Laserquelle umgibt und welche das Austrittsfenster beinhaltet.

3. Laserprojektor nach Anspruch 1, wobei das Beugungsgitter ein holographisches Beugungsgitter ist.

4. Laserprojektor nach Anspruch 1, wobei das Beugungsgitter ein Oberflächenrelief-Beugungsgitter ist.

5. Laserprojektor nach einem der Ansprüche 1 bis 4, wobei mindestens ein Teil des Beugungsgitters, der den optischen Pfad des Lichtstrahls überlappt, eine Resonanzwellenlänge aufweist, die der Wellenlänge des Lichtstrahls entspricht.

6. Laserprojektor nach einem der Ansprüche 1 bis 5, wobei die optische Maschine auf einer Oberfläche eines Substrats angeordnet ist, wobei der Photodetektor gegenüber einer Seitenwand des Austrittsfensters angeordnet ist, wobei die Seitenwand an die primäre Ausgangsfläche angrenzt und eine Ebene definiert, die senkrecht zu der Oberfläche des Substrats ist, und wobei das Beugungsgitter den Teil des Lichtstrahls durch die Seitenwand des Austrittsfensters in Richtung des Photodetektors umlenkt.

7. Laserprojektor nach einem der Ansprüche 1 bis 5, wobei die optische Maschine auf einem Substrat angeordnet ist, der Photodetektor direkt unter dem Austrittsfenster und direkt unter dem optischen Pfad des Lichtstrahls angeordnet ist und das Beugungsgitter den Teil des Lichtstrahls durch eine Bodenfläche des Austrittsfensters, die dem Substrat zugewandt ist, in Richtung des Photodetektors umlenkt.

8. Laserprojektor nach Anspruch 7, wobei der Photodetektor in das Substrat eingebettet ist.

9. Laserprojektor nach Anspruch 7, wobei die optische Maschine auf einer ersten Seite des Substrats angeordnet ist, der Photodetektor auf einer zweiten Seite des Substrats angeordnet ist, die der ersten Seite gegenüberliegt, und das Beugungsgitter den Teil des Lichtstrahls durch die Bodenfläche des Austrittsfensters und durch eine Apertur, die sich von der ersten Seite zu der zweiten Seite durch das Substrat erstreckt, in Richtung des Photodetektors umlenkt.

10. Laserprojektor nach einem der Ansprüche 1 bis 5, wobei die optische Maschine auf einem ersten Substrat angeordnet ist, der Photodetektor auf einem zweiten Substrat angeordnet ist, das über dem ersten Substrat derart angeordnet ist, dass der Photodetektor direkt über dem Austrittsfenster und dem optischen Pfad des Lichtstrahls angeordnet ist, und das Beugungsgitter den Teil des Lichtstrahls durch eine obere Fläche des Austrittsfensters, die in Richtung des zweiten Substrats gewandt ist und von dem ersten Substrat weg gewandt ist, in Richtung des Photodetektors umlenkt.

11. Laserprojektor nach einem der Ansprüche 1 bis 5, wobei die primäre Ausgangsfläche des Austrittsfensters in Bezug auf die primäre Eingangsfläche des Austrittsfensters geneigt ist, wobei der Lichtstrahl auf die primäre Eingangsfläche des Austrittsfensters einfällt.

12. Laserprojektor nach einem der vorhergehenden Ansprüche, wobei die optische Maschine umfasst:
eine Vielzahl von Laserquellen, die konfiguriert sind, um eine Vielzahl von Lichtstrahlen auszugeben;
eine Umhüllung, welche die Vielzahl von Laserquellen umgibt, wobei die Umhüllung das Austrittsfenster aufweist, das in jedem optischen Pfad der Vielzahl von Lichtstrahlen angeordnet ist, die von der Vielzahl von Laserquellen ausgegeben werden, wobei das Beugungsgitter einen Teil von jedem der Vielzahl von Lichtstrahlen in Richtung des mindestens einen Photodetektors umlenkt.

13. Laserprojektor nach Anspruch 12, ferner umfassend eine Kollimationslinse zwischen dem Austrittsfenster und dem mindestens einen Photodetektor.

14. Laserprojektor nach Anspruch 12 oder 13, wobei das Beugungsgitter umfasst:
einen ersten Teil mit einer ersten Resonanzwellenlänge, die einer ersten Wellenlänge eines ersten Lichtstrahls der Vielzahl von Lichtstrahlen entspricht, wobei der erste Teil einen ersten optischen Pfad des ersten Lichtstrahls überlappt; und
einen zweiten Teil mit einer zweiten Resonanzwellenlänge, die einer zweiten Wellenlänge eines zweiten Lichtstrahls der Vielzahl von Lichtstrahlen entspricht, wobei der zweite Teil einen zweiten optischen Pfad des zweiten Lichtstrahls überlappt.

15. Laserprojektor nach einem der Ansprüche 12 bis 14, wobei die optische Maschine auf einer Oberfläche eines Substrats angeordnet ist, der mindestens eine Photodetektor einen ersten Photodetektor umfasst, der gegenüber einer ersten Seitenwand des Austrittsfensters der Umhüllung angeordnet ist, die erste Seitenwand an die primäre Ausgangsfläche angrenzt und eine Ebene definiert, die senkrecht zu der Oberfläche des Substrats ist, und das Beugungsgitter einen ersten Teil von mindestens einem ersten Lichtstrahl der Vielzahl von Lichtstrahlen durch die erste Seitenwand des Austrittsfensters in Richtung des ersten Photodetektors umlenkt, wobei der mindestens eine Photodetektor ferner einen zweiten Photodetektor umfasst, der gegenüber einer zweiten Seitenwand des Austrittsfensters der Umhüllung angeordnet ist, die zweite Seitenwand der ersten Seitenwand gegenüberliegt, und das Beugungsgitter einen zweiten Teil von mindestens einem zweiten Lichtstrahl der Vielzahl von Lichtstrahlen durch die zweite Seitenwand des Austrittsfensters in Richtung des zweiten Photodetektors umlenkt.

## Revendications

1. Projecteur laser (400, 500, 600, 700, 800, 900) comprenant :
au moins un photodétecteur (410, 510, 610-1, 610-2, 710, 810, 910) configuré pour mesurer l'intensité lumineuse ; et
un moteur optique (402, 502, 602, 702, 802, 902) comprenant :
au moins une source laser (412-1, 412-2, 412-3, 512-1, 512-2, 512-3, 612-1, 612-2, 612-3, 712, 812, 912) configurée pour délivrer en sortie un faisceau lumineux ;
une fenêtre de sortie (414, 514, 614, 714, 814, 914) disposée dans un trajet optique du faisceau lumineux délivré en sortie par la source laser, dans lequel la fenêtre de sortie reçoit le faisceau lumineux via une surface d'entrée principale de la fenêtre de sortie ;
**caractérisé en ce que**
le moteur optique comprend un réseau de diffraction (416, 516, 616, 716, 816, 916) disposé sur une surface de sortie principale de la fenêtre de sortie,
dans lequel le réseau de diffraction est configuré pour rediriger une partie du faisceau lumineux en direction du photodétecteur à travers au moins une surface de la fenêtre de sortie qui s'étend entre la surface d'entrée principale et la surface de sortie principale.

2. Projecteur laser selon la revendication 1, comprenant en outre :
une enceinte qui entoure la source laser et qui comporte la fenêtre de sortie.

3. Projecteur laser selon la revendication 1, dans lequel le réseau de diffraction est un réseau de diffraction holographique.

4. Projecteur laser selon la revendication 1, dans lequel le réseau de diffraction est un réseau de diffraction à relief de surface.

5. Projecteur laser selon l'une quelconque des revendications 1 à 4, dans lequel au moins une partie du réseau de diffraction qui chevauche le trajet optique du faisceau lumineux a une longueur d'onde de résonance correspondant à la longueur d'onde du faisceau lumineux.

6. Projecteur laser selon l'une quelconque des revendications 1 à 5, dans lequel le moteur optique est disposé sur une surface d'un substrat, dans lequel le photodétecteur est disposé en regard d'une paroi latérale de la fenêtre de sortie, dans lequel la paroi latérale est adjacente à la surface de sortie principale et définit un plan qui est perpendiculaire à la surface du substrat, et dans lequel le réseau de diffraction redirige la partie du faisceau lumineux en direction du photodétecteur à travers la paroi latérale de la fenêtre de sortie.

7. Projecteur laser selon l'une quelconque des revendications 1 à 5, dans lequel le moteur optique est disposé sur un substrat, le photodétecteur est disposé directement sous la fenêtre de sortie et directement sous le trajet optique du faisceau lumineux, et le réseau de diffraction redirige la partie du faisceau lumineux en direction du photodétecteur à travers une surface inférieure de la fenêtre de sortie qui fait face au substrat.

8. Projecteur laser selon la revendication 7, dans lequel le photodétecteur est intégré dans le substrat.

9. Projecteur laser selon la revendication 7, dans lequel le moteur optique est disposé sur une première face du substrat, le photodétecteur est disposé sur une seconde face du substrat qui est opposée à la première face, et le réseau de diffraction redirige la partie du faisceau lumineux en direction du photodétecteur à travers la surface inférieure de la fenêtre de sortie et à travers une ouverture qui s'étend à travers le substrat depuis la première face vers la seconde face.

10. Projecteur laser selon l'une quelconque des revendications 1 à 5, dans lequel le moteur optique est disposé sur un premier substrat, le photodétecteur est disposé sur un second substrat qui est disposé au-dessus du premier substrat de telle sorte que le photodétecteur est disposé directement au-dessus de la fenêtre de sortie et du trajet optique du faisceau lumineux, et le réseau de diffraction redirige la partie du faisceau lumineux en direction du photodétecteur à travers une surface supérieure de la fenêtre de sortie qui est orientée en direction du second substrat et qui est orientée à l'opposé du premier substrat.

11. Projecteur laser selon l'une quelconque des revendications 1 à 5, dans lequel la surface de sortie principale de la fenêtre de sortie est inclinée par rapport à la surface d'entrée principale de la fenêtre de sortie, dans lequel le faisceau lumineux est incident sur la surface d'entrée principale de la fenêtre de sortie.

12. Projecteur laser selon l'une quelconque des revendications précédentes, dans lequel le moteur optique comprend :
une pluralité de sources laser configurées pour délivrer en sortie une pluralité de faisceaux lumineux ;
une enceinte qui entoure la pluralité de sources laser, l'enceinte ayant la fenêtre de sortie disposée dans chaque trajet optique de la pluralité de faisceaux lumineux délivrés en sortie par la pluralité de sources laser, dans lequel le réseau de diffraction redirige une partie de chacun de la pluralité de faisceaux lumineux en direction de l'au moins un photodétecteur.

13. Projecteur laser selon la revendication 12, comprenant en outre une lentille de collimation située entre la fenêtre de sortie et l'au moins un photodétecteur.

14. Projecteur laser selon la revendication 12 ou 13, dans lequel le réseau de diffraction comprend :
une première partie ayant une première longueur d'onde de résonance qui correspond à une première longueur d'onde d'un premier faisceau lumineux de la pluralité de faisceaux lumineux, où la première partie chevauche un premier trajet optique du premier faisceau lumineux ; et
une seconde partie ayant une seconde longueur d'onde de résonance qui correspond à une seconde longueur d'onde d'un second faisceau lumineux de la pluralité de faisceaux lumineux, où la seconde partie chevauche un second trajet optique du second faisceau lumineux.

15. Projecteur laser selon l'une quelconque des revendications 12 à 14, dans lequel le moteur optique est disposé sur une surface d'un substrat, l'au moins un photodétecteur comprend un premier photodétecteur qui est disposé en regard d'une première paroi latérale de la fenêtre de sortie de l'enceinte, la première paroi latérale est adjacente à la surface de sortie principale et définit un plan qui est perpendiculaire à la surface du substrat, et le réseau de diffraction redirige une première partie d'au mois un premier faisceau lumineux de la pluralité de faisceaux lumineux en direction du premier photodétecteur à travers la première paroi latérale de la fenêtre de sortie, dans lequel l'au moins un photodétecteur comprend en outre un second photodétecteur qui est disposé en regard d'une seconde paroi latérale de la fenêtre de sortie de l'enceinte, la seconde paroi latérale est opposée à la première paroi latérale, et le réseau de diffraction redirige une seconde partie d'au mois un second faisceau lumineux de la pluralité de faisceaux lumineux en direction du second photodétecteur à travers la seconde paroi latérale de la fenêtre de sortie.
